# EUROPEAN PATENT APPLICATION

(11) **EP 4 797 935 A1**
(43) Date of publication of application: **26.08.2026**
(21) Application number: 26156076.7
(22) Date of filing: 03.02.2026
(51) Int. Cl.: H10W 42/00, H10W 90/20, H10W 70/63

(54) **THICK GATE OXIDE AND RF-ONLY INTERPOSER WITH ALUMINUM VIA AND EDGE SEAL STRUCTURES**

(30) Priority: 18.02.2025 IN 202541013714
(71) Applicant: NXP USA, Inc., Austin, TX 78735 (US)
(72) Inventor: Reber, Douglas Michael, 5656AG Eindhoven (NL); Bhooshan, Rishi, 5656AG Eindhoven (NL)
(74) Representative: Schwarzweller, Thomas

(57) **Abstract**

An interposer structure and fabrication method are disclosed by providing a wafer substrate in which is formed FEOL transistors with gate oxides having a minimum specified thickness, forming a BEOL ILD stack with interconnect structures on the wafer substrate, selectively etching openings extending at least part way down through the BEOL ILD stack, filling the etch openings with at least deposited aluminum to form a plurality of aluminum via structures and aluminum crack stop structures extending from a top surface of the BEOL ILD stack at least part way down through the BEOL ILD stack, and partially recessing a bottom surface of the wafer substrate layer to expose at least the aluminum crack stop structures.

## Description

### BACKGROUND OF THE INVENTION

### Field of the Invention

The present disclosure is directed in general to the field of semiconductor devices. In one aspect, the present disclosure relates to integrated circuit interposers for electrically connecting integrated circuit dies or modules to an electrical apparatus.

### Description of the Related Art

Modern integrated circuits (ICs) typically have conductor structures formed in a plurality of inter-layer dielectric (ILD) layers to provide conductive interconnect levels, which provide electrical connections to and from circuitry that is formed on the IC substrate. These conductors can be used to transfer information in the form of signals sent to and from ICs formed on an underlying substrate. In addition, conductor structures may be formed in the ILD layers to provide other circuit elements, such as capacitor plates that are electrically connected to the circuitry that is formed on the IC substrate. After forming the circuitry on the substrate during front-end-of-line (FEOL) processing, existing copper metallization techniques for semiconductor wafer-fabrication form inter-level conductor structures in a series of ILD layers by patterning and etching each ILD layer to form etch openings, plating, and/or filling each etch opening with one or more conductive layers, and then applying a chemical-mechanical planarization (CMP) or polish step to remove the conductive layer(s) from outside the etch openings.

With shrinking technology and increasing power consumption, interconnect resistance (IR) drop through the conductive interconnect levels is becoming a very significant problem for designs using wire-bond packaging. When the power demand becomes too great, the number and thickness of the patterned aluminum (ALUCAP) final metallization can be increased in the die interconnects and/or flip-chip packaging should be employed, but such solutions will increase die and packaging cost. Other solutions for meeting increased power requirements include forming copper pillar conductors at interior regions of the die which make direct electrical contact through the interconnect to the circuit elements on the die (instead of travelling "laterally" from die pads at the periphery of the die). While these power delivery solutions may be workable for older technology nodes, the required rules for metal and via lines and spaces for more advanced nodes can cause significant congestion challenges when designing the other circuit connections. For example, the more advanced nodes are fabricated with critical and very expensive silicon technology to comply with the optical constraints caused by double and triple patterning and uniformity needs for such the advanced node devices. On the other hand, as the technology node is advanced, the number of power and ground delivery connections increases non-linearly, and the resistance of the constituent lines and vias also increases non-linearly. While some solutions have proposed to address the power delivery challenge with more advanced nodes by forming Copper through silicon via (TSV) structures through the completed back-end-of-line (BEOL) stack, the stresses from the Copper via structures will likely cause issues with Silicon-to-Model disconnects which can cause dramatic shifts in the threshold voltage Vt and mobility for core devices and especially RF/analog devices.

As seen from the foregoing, existing designs and fabrication processes for IC devices have not provided a power delivery solution for connecting the top-side Aluminum metal to the front-end-of-line (FEOL) devices while avoiding the resistance and spatial constraints required for leading-edge IC devices. In addition, existing advanced node technologies suffer from potential product delays resulting from product redesign and tapeout delays if any of the density and placement constraints are not respected or if late changes to the rules are made by the wafer foundry. Further limitations and disadvantages of conventional processes and technologies will become apparent to one of skill in the art after reviewing the remainder of the present application with reference to the drawings and detailed description which follow.

### BRIEF DESCRIPTION OF THE DRAWINGS

The present invention may be understood, and its numerous objects, features and advantages obtained, when the following detailed description of a preferred embodiment is considered in conjunction with the following drawings.

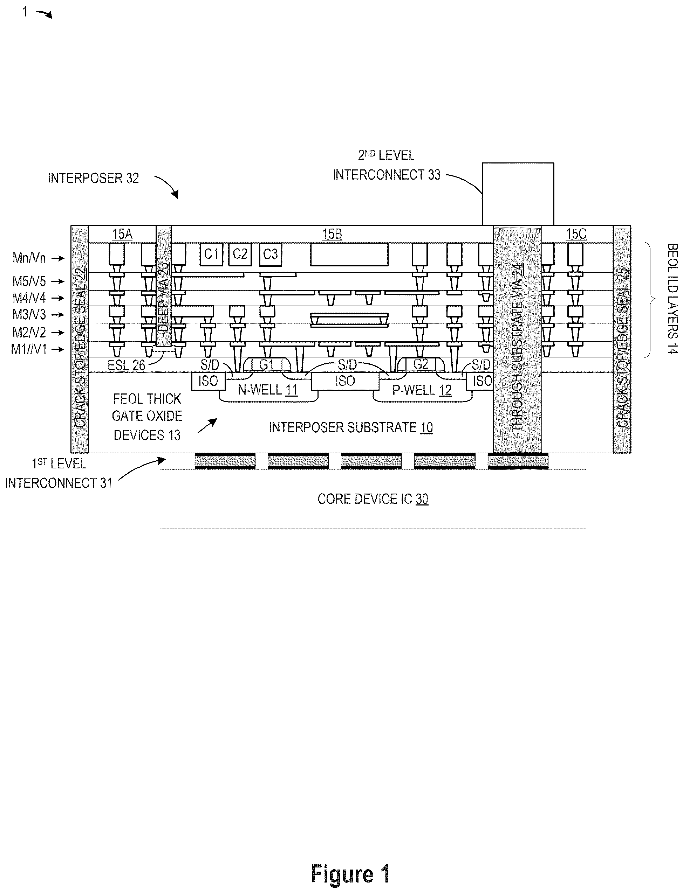

Figure 1 shows a cross-sectional view of an interposer structure connected to a core device chip in accordance with selected embodiments of the present disclosure.

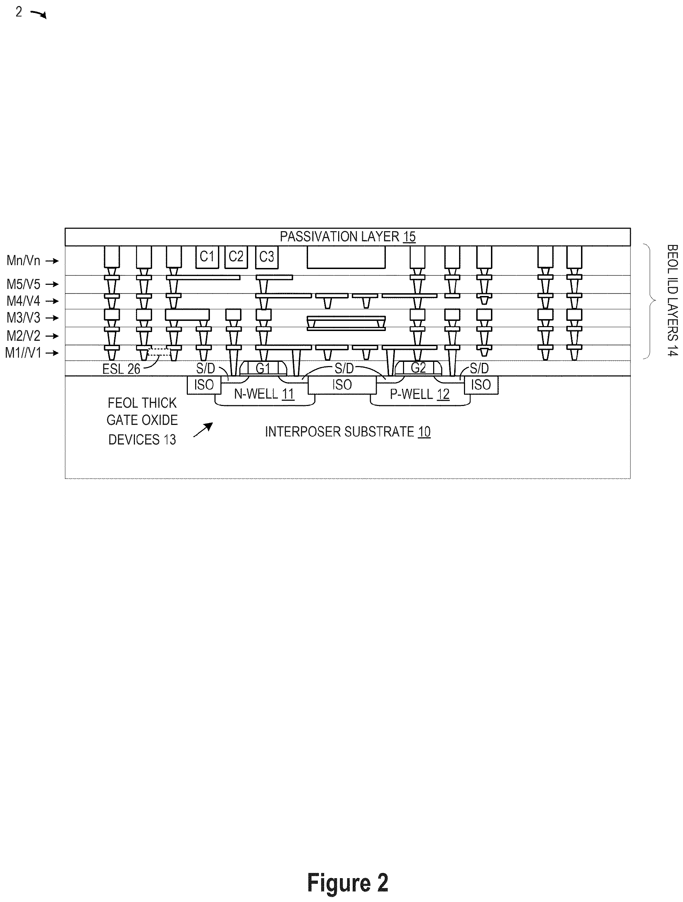

Figures 2-8 show cross-sectional views of a sequence of steps for fabricating the interposer structure with full and partial stack Aluminum via structures and seal ring/crack stop structures formed in the BEOL ILD/interconnect layers in accordance with first selected embodiments of the present disclosure.

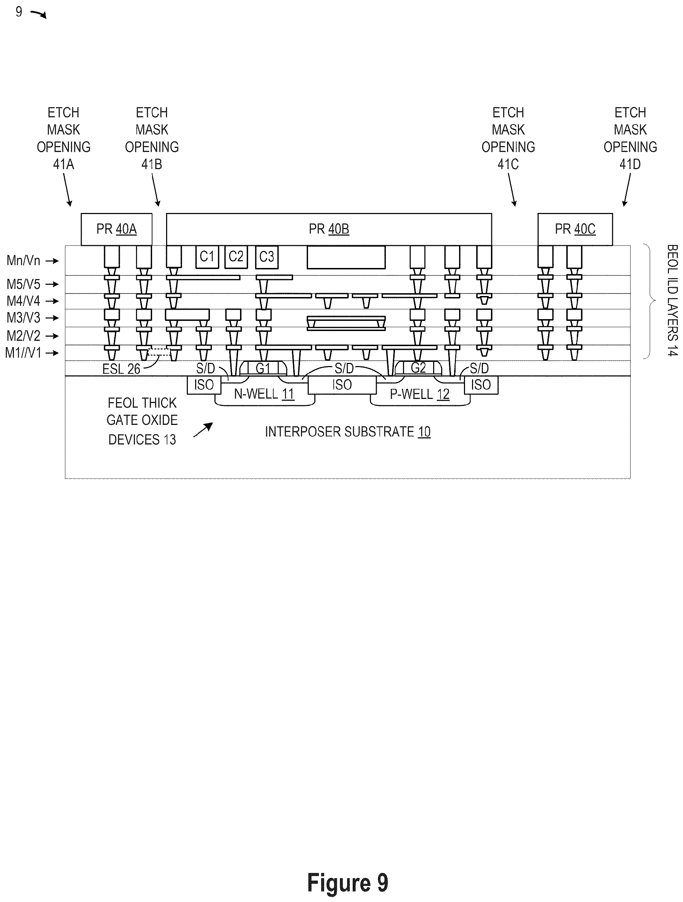

Figures 9-14 show cross-sectional views of a sequence of steps for fabricating the interposer structure with full and partial stack Aluminum seal ring/crack stop structures and vias formed in the BEOL ILD/interconnect layers in accordance with alternative selected embodiments of the present disclosure.

### DETAILED DESCRIPTION

A process for fabricating integrated circuit (IC) devices is described wherein an interposer structure includes selected non-core device components (such as thick gate oxide transistors and/or radio frequency (RF) elements) formed in an interposer substrate layer and full back-end-of-line (BEOL) interconnect stack having via structures and seal ring/crack stop structures which are formed in the full BEOL interconnect stack by selectively etching deep trench openings in the full BEOL interconnect stack to one or more predetermined depths and then filling the deep trench openings with a barrier liner layer and deposited Aluminum to form Aluminum via structures and seal ring/crack stop structures. By forming a low cost interposer structure to include non-core device components, selected core device components (such as advanced node core transistors or memory transistors) can be formed in an advanced-node, costly silicon high speed die that is connected to the low cost interposer structure by suitable conductors. In selected embodiments, the interposer structure is formed to include only non-core device components, such as thick gate oxide devices having a minimum specified gate oxide thickness (e.g., 50-200 Angstroms), capacitors, inductors, and/or radio frequency (RF) passive devices, but does not include any core device components, such as advanced node core transistors or memory transistors. In such embodiments, the advanced-node, costly silicon high speed die is formed to include only core device components, such as advanced node core transistors or memory transistors having a smaller maximum specified gate oxide thickness (e.g., 20-40 Angstroms). In this way, the functional circuitry is divided between the low cost interposer structure and advanced-node, costly silicon high speed die so that the wafer cost and cycle time for the interposer structure is greatly reduced by virtue of providing Aluminum via structures and seal ring/crack stop structures in the interposer structure which do not require compliance with design protections for threshold voltages and critical patterning. And by forming the Aluminum via structures and seal ring/crack stop structures in the interposer structure, the non-core device components (such as thick gate oxide transistors, input/output transistors, capacitors, large area inductors, and/or other RF passive devices) may be formed with a minimal number of BEOL interconnect stack layers on the interposer structure. In accordance with the present disclosure, the interposer structure may include transistors with different gate oxide thicknesses that exceed a minimum oxide thickness, or may include transistors which all have the same thick gate oxide thickness.

In this disclosure, an improved IC structure and method of manufacture are described for forming conductive via structures and seal ring/crack stop structures in the full BEOL interconnect stack of an interposer structure so as to promote a low IR drop interposer structure which hosts IC device components that would otherwise interfere with the fabrication of high performance IC device components formed on a shared semiconductor substrate layer, thereby addressing various problems in the art where various limitations and disadvantages of conventional solutions and technologies will become apparent to one of skill in the art after reviewing the remainder of the present application with reference to the drawings and detailed description provided herein. Various illustrative embodiments of the present invention will now be described in detail with reference to the accompanying figures. While various details are set forth in the following description, it will be appreciated that the present invention may be practiced without these specific details, and that numerous implementation-specific decisions may be made to the invention described herein to achieve the device designer's specific goals, such as compliance with process-technology requirements or design-related constraints, which will vary from one implementation to another. While such a development effort might be complex and time-consuming, it would nevertheless be a routine undertaking for those of ordinary skill in the art having the benefit of this disclosure. For example, selected aspects are depicted with reference to simplified cross-sectional drawings of a semiconductor device without including every device feature or geometry in order to avoid limiting or obscuring the present invention. Such descriptions and representations are used by those skilled in the art to describe and convey the substance of their work to others skilled in the art. It is also noted that, throughout this detailed description, certain elements in the figures are illustrated for simplicity and clarity and have not necessarily been drawn to scale. In addition, the dimensions of some of the elements in the figures may be exaggerated relative to other elements to help improve the understanding of the embodiments of the present disclosure. Further, reference numerals have been repeated among the drawings to represent corresponding or analogous elements. In addition, the depicted device layers that are shown as being deposited and/or etched are represented with simplified line drawings, though it will be appreciated that, in reality, the actual contours or dimensions of device layers will be non-linear, such as when the described etch processes are applied at different rates to different materials, or when the described deposition or growth processes generate layers based on the underlaying materials.

For an improved understanding of selected embodiments of the present disclosure, reference is now made to Figure 1 which depicts a simplified cross-section view of an integrated circuit package assembly 1 which includes one or more core device integrated circuits 30 affixed or mounted with first level interconnects 31 to an interposer structure 32, the details of which are described more fully hereinbelow. When implemented as a flip chip package, the first level interconnects 31 connecting the discrete core device IC chip(s) 30 to the interposer structure 32 may be implemented as copper pillars, solder balls, conductive rails, or any other standard attachment method. In addition, the interposer structure 32 is attached to one or more second level interconnects 33 for connecting the interposer structure 32 to external circuits, such as a printed circuit board (not shown). As depicted, the core device IC chip 30 is positioned and arranged with face-up patterned conductors for aligned attachment to the first level interconnects 31 which, in turn, are positioned and arranged for aligned attachment to face-down patterned conductors on the interposer 32. For example, the first level interconnects 31 may be implemented with an array of conductive die rails that are aligned and positioned to make direct electrical connection between the core device IC chip 30 and the interposer 32. However, it will be appreciated that core device IC chip 30 may be positioned and arranged with face-down patterned conductors for aligned attachment over interconnects to the top of the interposer 32 which, in turn, is positioned and arranged for aligned attachment over interconnects on the bottom of the interposer 32. Though not shown, it will be appreciated that a redistribution line (RDL) stack layer may be formed on the upper surface of the core device IC 30 and/or the bottom surface of the interposer 32 to provide fine-pitch routing layers.

Various illustrative embodiments of the present invention will now be described in detail with reference to Figures 1-14. In addition, although specific example materials, thicknesses, and processes are described herein, those skilled in the art will recognize that other materials, thicknesses, and processes with similar properties or characteristics can be substituted without loss of function. It is noted that, throughout this detailed description, certain layers of materials will be deposited and removed to form the interposer structure. Where the specific procedures for processing such layers or thicknesses of such layers are not detailed below, conventional techniques known to one skilled in the art for depositing, removing, forming, or otherwise processing such layers at appropriate thicknesses shall be intended. Such details are well known and not considered necessary to teach one skilled in the art how to make or use the present invention.

For an improved understanding of selected embodiments of the present disclosure, reference is now made to Figures 2-14 which illustrate a sequence of cross-sectional views at different stages of manufacture of an interposer structure having full and partial stack Aluminum via structures and seal ring/crack stop structures formed in the BEOL ILD/interconnect layers. In particular, Figure 2 illustrates a cross-sectional view a portion of an interposer structure 2 which may be formed as part of a semiconductor wafer wherein one or more BEOL inter-layer dielectric (ILD) layers 14 are formed over an interposer semiconductor substrate 10 in which one or more thick gate oxide IC devices or elements 13 are fabricated with FEOL wafer-processing steps. As will be appreciated, the FEOL thick gate oxide IC devices or elements 13 may include one or more transistors, resistors, capacitors, diodes, or other semiconductor components that are formed on or in a semiconductor substrate 10 with any suitable semiconductor material or combinations of materials, such as Gallium Arsenide, Gallium Nitride, Silicon Germanium, semiconductor-on-insulator (SOI), strained semiconductor-on-insulator (SSOI), Silicon, monocrystalline Silicon, and the like. As depicted, the transistors may include gates G1, G2 and one or more relatively thick gate dielectric or oxide layers having a first minimum thickness (e.g., 50-200 Angstroms) that are formed over the interposer semiconductor substrate 10 in which source/drain (S/D) regions and channel regions formed in an n-well 11 or p-well 12. In addition, the transistors may be separated from one another by isolation regions (ISO). Typically, such thick gate oxide devices are used for high voltage transistors, such as I/O transistors, but the interposer structure 2 may include any slower-performing circuit components, such as static random access memories (SRAM), read only memories (ROM), electrically-programmable ROM (EPROM) devices, electrically-programmable fuses, or the like. Stated another way, the interposer structure 2 may include any circuit components which do not need to operate at the high speed and/or necessitates thin gate oxide devices.

Over the IC elements, one or more BEOL ILD layers 14 may be formed with any suitable insulating material to separate and define patterned conductive metal lines or layers M1-Mn and vias V1-Vn formed therein. As depicted, a plurality of patterned conductive metal lines or layers M1-Mn and vias V1-Vn may be vertically stacked or otherwise electrically connected together to create a conductive path for signal or power to be conveyed through the BEOL ILD layers 14 to the FEOL thick gate oxide IC devices or elements 13, with the patterned conductive metal line and via structures in each level being formed in the inter-level dielectric layer for that level. While the stacked BEOL ILD layers 14 are depicted as including vertical stacks of patterned conductive metal line and via structures in the levels 1-n, it will be appreciated that this is a simplified illustration, and other conductive paths may be established in the stacked BEOL ILD layers 14. It will also be appreciated that the stacked BEOL ILD layers 14 may include additional elements at individual layers. For example, an etch stop layer (ESL) 26 may be formed and positioned in the first ILD layer with a suitable etch stop material (e.g., a metal or other suitable etch stop material) so that a subsequent dielectric etch process that is applied to the stacked BEOL ILD layers 14 will stop at the ESL 26.

As will be appreciated, one or more IC elements may be formed with the patterned conductive metal lines in the BEOL ILD layers 14. For example, an IC capacitor element, such as a decoupling capacitor, may be formed with the depicted capacitor elements C1-C3 in the final metal layer Mn. In addition or in the alternative an IC inductor element, such as a large area inductor, may be formed with the conductive inductor elements (not shown) in the patterned conductive metal lines or layers. Generally speaking, any RF passive device may be formed with the patterned conductive metal lines or layers in the stack of BEOL ILD layers 14.

Upon completion of the stack of BEOL ILD layers 14, a passivation layer 15 is formed over the top surface of the BEOL ILD layers 14. While any suitable fabrication process may be used, the passivation layer 15 may be formed by depositing one or more suitable dielectric passivation layers (e.g., polyimide, SiN, SiC, SiCN, SiON, SiOₓ, SiₓN_{y}, SiCON, a-C or combinations and variations thereof, some of which may also be flourinated) to a predetermined thickness. At this point in the fabrication process, conductive pillar conductors, such as the final termination Aluminum layer, have not been formed over the interposer structure 2 for connection to the buried conductors formed in the BEOL ILD layers 14.

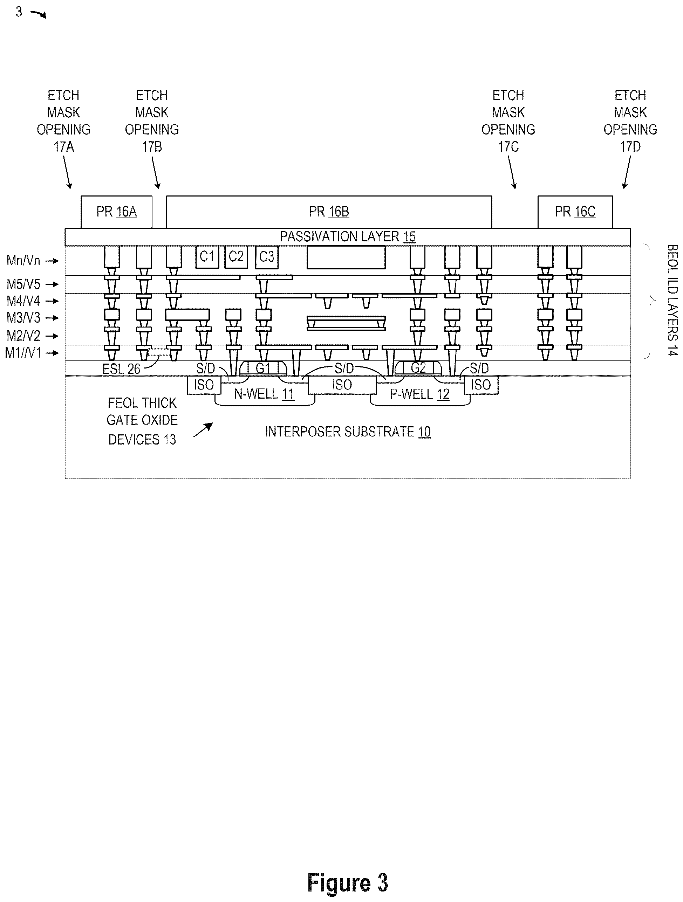

Figure 3 illustrates processing of the interposer structure 3 subsequent to Figure 2 after patterning the passivation layer 15 with a patterned etch mask or photoresist (PR) layer 16A-C in which patterned etch mask openings 17A-D expose a top surface of the passivation layer 15 in accordance with selected embodiments of the present disclosure. While any suitable photoresist patterning process may be used, the patterned photoresist mask 16A-C may be formed on the passivation layer 15 by depositing, patterning, etching or developing a photoresist layer formed with any material that is suitable for photolithography. For example, the patterned photoresist mask 16A-Cmay be formed by coating the passivation layer 15 with a light-sensitive organic material, applying a light source with a patterned mask over the surface of the wafer substrate which blocks light so that only unmasked regions of the material will be exposed to light, and applying a solvent to develop the material so that photo-sensitive material degraded by light and the developer will dissolve away the regions that were exposed to light, leaving behind a PR coating 16A-C where the mask was placed and etch mask openings 17A-D where the coating is removed. In this way, the patterned photoresist mask 16A-C includes defined openings 17A-D which expose the underlying passivation layer 15 at intended etch locations for the full and partial stack via structures and seal ring/crack stop structures will be formed at specified locations in the BEOL ILD 14. In selected embodiments, the patterned etch mask openings 17A-D can extend substantially over the top surface of the interposer structure 3. In other embodiments, the patterned the etch mask openings 17A-D can define openings of any desired size or shape (e.g., a 2x2um or 3x3 um sized via) for the finally formed full and partial stack via structures and seal ring/crack stop structures.

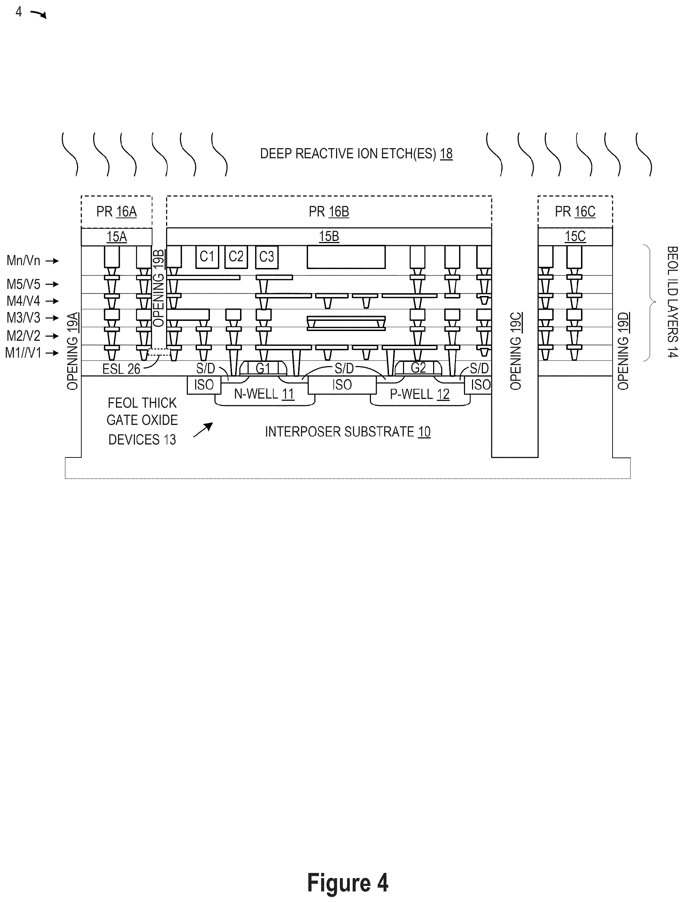

Figure 4 illustrates processing of the interposer structure 4 subsequent to Figure 3 after selectively etching openings 19A-D through the passivation layer 15 and underlying stack of BEOL ILD layers 14 exposed by the etch mask openings 17A-D in the patterned photoresist mask 16A-C in accordance with selected embodiments of the present disclosure. As will be understood by those skilled in the art, the selective etch process may use any suitable anisotropic etch process(es) 18 to form the etching openings 19A-D which extend through the passivation layer 15 and underlying stack of BEOL ILD layers 14 to a predetermined depth. For example, with the patterned photoresist mask 16A-C defined to include etch mask openings 17A-D having wider width dimensions for the etch openings 19A, 19C, 19D and narrower width dimensions for the etch opening 19B, a single deep reactive-ion etch (RIE) step 18 having suitable etch chemistry properties may be applied to remove the exposed portions of the underlying stack of BEOL ILD layers 14 to form the etching openings 19A-D having different depths as shown, where the depth of each etch opening 19A-D is based on the relative size of the width dimensions of the etch mask openings 17A-D. Since the intention is for the deep trench etch opening 19A-D to form conductive TSV/pillars at selected locations (e.g., 19C), the diameter of such deep trench etch openings 19C may be limited to what can be filled completely with one or more subsequent metal (e.g., Aluminum) deposition steps.

In an example embodiment, a controlled etch process 18, such as a timed anisotropic dry etch, may be applied to form high-aspect ratio openings 19A-D. Alternatively and as indicated by the dashed lines of the patterned photoresist mask 16A-C, separate patterned etch masks and deep RIE etch processing steps may be applied to define the relatively shallow etch opening 19B and the relatively deep etch openings 19A, 19C-D. In yet another embodiment, an etch stop layer (ESL) 26 formed in the stacked BEOL ILD layers 14 may be used to stop the progress of the etch process 18 so that the depth of the etch opening 19B is controlled. As disclosed herein, the ESL 26 may be formed with any suitable etch stop material (e.g., a metal or other suitable etch stop material) so that the etch process 18 will stop at the ESL 26. While the sidewalls of the etch opening 19A-D are shown as being substantially vertical, it will be appreciated that minor deviations in the sidewall profile may occur due to etch processing variations. It will also be appreciated that the locations of the via openings 19B-C are not necessarily constrained to being adjacent to consecutive patterned metal layers as shown, nor is there a requirement of having no metal interactions. The patterned metal layers in the BEOL ILD layers 14 can be made to impede, constrain, or connect to the full-stack via as needed for the best circuit design. Finally, the etching openings 19A-D are depicted as being formed at different levels of the six metal layer stack in the BEOL ILD layers 14, but it will be appreciated that additional or fewer metal layers may be used in the interposer structure 4.

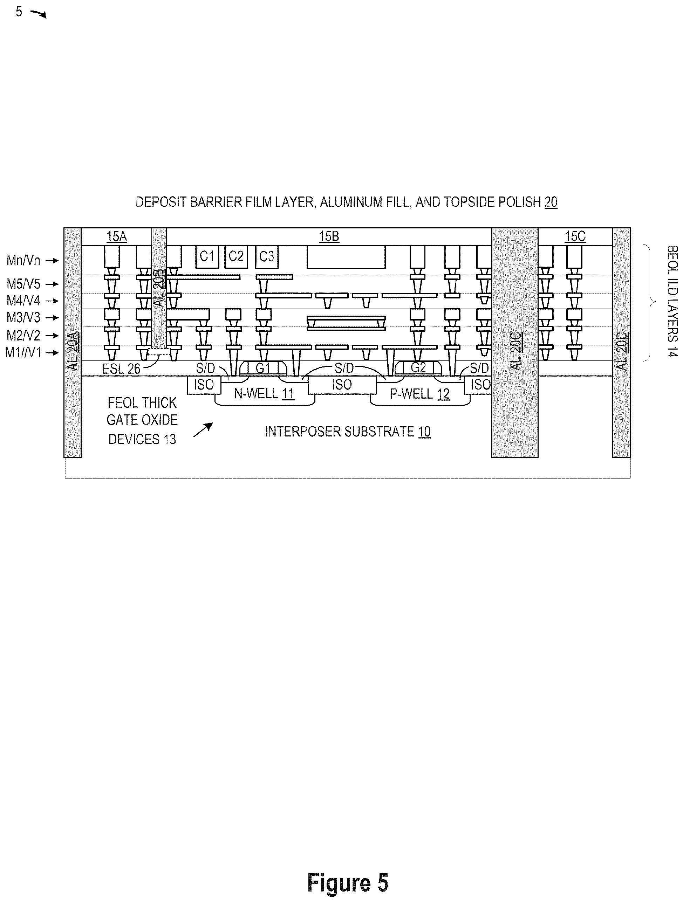

Figure 5 illustrates processing of the interposer structure 5 subsequent to Figure 4 after stripping the patterned photoresist mask 16A-C and filling the etch openings 19A-D with one or more deposited metal layers 20A-D in accordance with selected embodiments of the present disclosure. While any suitable fabrication process may be used, the etch openings 19A-D may be filled with any suitable sequence of steps 20 for depositing a barrier film layer and aluminum fill layer and then applying a topside polish step to planarize the deposited metal layers 20A-D with the passivation layer 15. For example, the etch openings 19A-D may be filled by first depositing, over the top surface of the interposer structure 5 and along the interior sidewalls of the etch openings 19A-D, a conductive barrier film or liner layer of any suitable diffusion barrier material which also allows for electrodeposition (e.g., Ti, TiN, Ta, TaN, TiN, TiC, TaC, CuWP, or the like). On the conductive barrier film/liner layer, the deposited metal layers 20A-D may then be formed by filling the remainder of the etch openings 19A-D with metallic material, such as by using electroplating, electroless plating, or depositing Aluminum to fill the etch openings 19A-D, though other suitable conductive materials (e.g., Cu, Co, Ni, Mn, Mg, Zn, etc.) may be used in other embodiments. The electroplating process may be controlled to provide a bottom-up electroplating so that the metallic material is formed only on horizontal surfaces to cover the bottom of the etch openings, and to make direct electrical contact with any exposed underlying metal conductive layers in the BEOL ILD layers 14. The deposited metal layers 20A-D may then be planarized with a topside polish step, such as by using a chemical mechanical polish (CMP) planarization process. In other embodiments, the deposited metal layers 20A-D may be patterned and selectively etched to form Aluminum pillars or posts that extend above the passivation layer 15.

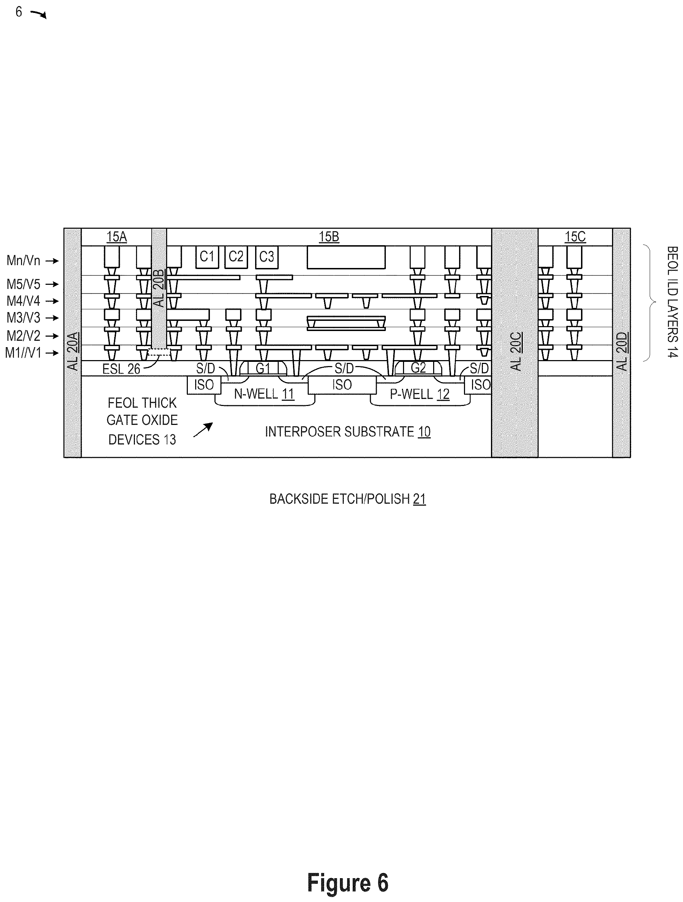

Figure 6 illustrates processing of the interposer structure 6 subsequent to Figure 5 after performing a backside etch or polish step 21 in accordance with selected embodiments of the present disclosure. While any suitable fabrication process may be used, the backside etch processing 21 may be applied to expose the deeper metal layers 20A, 20C-D on the back surface of the etched interposer substrate 10, such as by applying one or more thinning etch processes to planarize the interposer substrate 10 with the metal layers 20A, 20C-D. In other embodiments, the backside etch processing 21 may use a chemical mechanical polish (CMP) planarization process to thin the interposer substrate 10 and expose the metal layers 20A, 20C-D. In any case, the backside etch or polish step 21 may be applied to thin the interposer substrate 10 until it reaches the bottom of the metal layers 20A, 20C-D, or may be applied to etch the interposer substrate 10 and bottom of the metal layers 20A, 20C-D into a thinner planarized substrate structure.

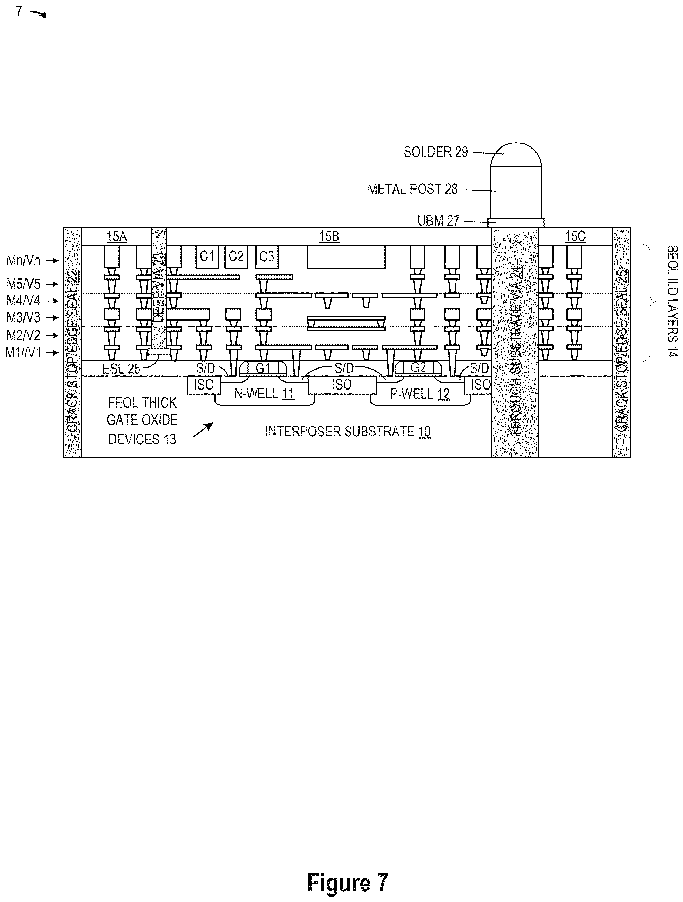

Figure 7 illustrates processing of the interposer structure 7 subsequent to Figure 6 after forming a second level interconnect in accordance with selected embodiments of the present disclosure. At this point in the fabrication process, the outer metal layers 20A, 20D formed at the periphery of the interposer substrate 10 are part of a continuous or segmented crack stop or edge seal ring 22 which surrounds the interior circuit structures of the interposer structure 6 to increase crack resistance during the dicing of the semiconductor wafer in which the interposer structure 5 is formed. In addition, the inner metal layer 20B is an example of a conductive spike via 23 which extends partially into the BEOL ILD layers 14 to make contact with one or more of the patterned metal layers. And the inner metal layer 20C is an example of a conductive through substrate via (TSV) 24 which extends through the entirety of the BEOL ILD layers 14. In contact with the conductive TSV 24 at the top of the interposer 7, a second level interconnect structure may be formed, such as a C4 bump, copper pillar pad and solder cap, under bump metallization, or the like. For example, the second level interconnect may be fabricated by forming a patterned under bump metallization (UBM) layer 27 with one or more conductive layers to contact and cover the conductive TSV 24, such as by depositing, patterning, and etching one or more conductive layers over the interposer structure 7. On the UBM layer 27, a metal post or pillar 28 may be fabricated, such as by forming a patterned polymer layer (not shown) over the interposer structure 7 with an opening over the UBM layer 27, and then depositing and etching or polishing one or more conductive layers, such as copper, over the interposer structure 7 to form the metal post 28. On the metal post 28, a solder ball connector 29 may be formed using any suitable bump flow. Of course, it will be appreciated that there are alternative structures and fabrication sequences for forming the second level interconnect structure.

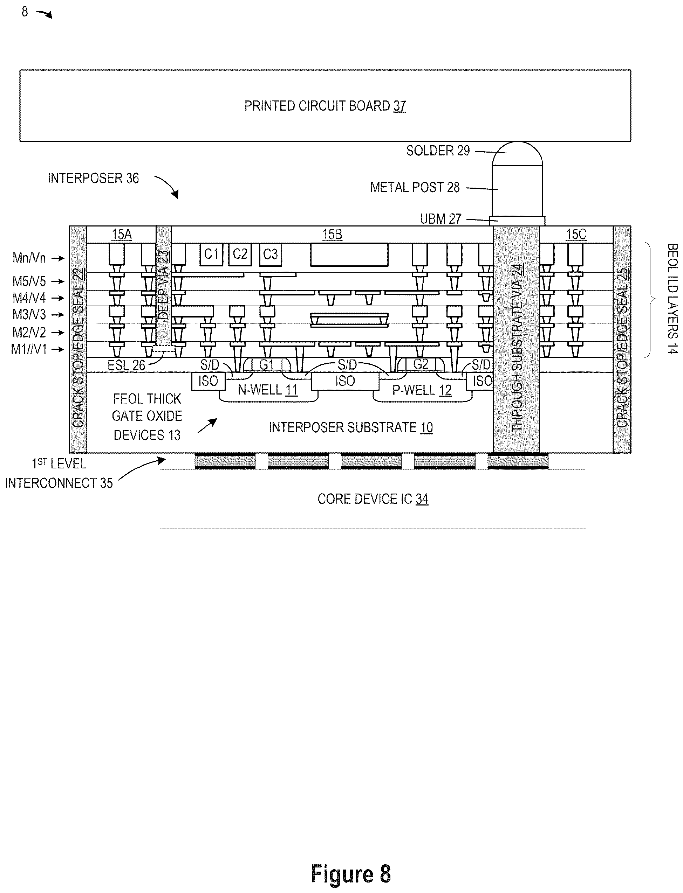

For an improved understanding of selected embodiments of the present disclosure, reference is now made to Figure 8 which depicts a simplified cross-section view of an integrated circuit package assembly 8 after affixing or mounting one or more core device integrated circuits 34 with first level interconnects 34 to an interposer structure 36. When implemented as a flip chip package, the core device IC 34 is connected to the printed circuit board 37 using defined conductive element paths in the interposer structure 36. In particular, the core device IC 34 is attached to a first or bottom surface of the interposer structure 36 using a set of first level interconnects 35, such as solder bumps or micro-bump conductors. In similar fashion, a second or top surface of the interpose structure 36 is attached to the printed circuit board 37 using a set of second level interconnects 27-29, such as a copper pillar solder ball or bump. As formed, the interposer structure 35 is formed to include only non-core device components, such as thick gate oxide devices having a minimum specified gate oxide thickness (e.g., 50-200 Angstroms), capacitors, inductors, and/or radio frequency (RF) passive devices, but does not include any core device components, such as advanced node core transistors or memory transistors. In addition, the core device IC 34 is formed to include only core transistor components, such as advanced node core transistors or memory transistors having a smaller maximum specified gate oxide thickness (e.g., approximately 20-40 Angstroms). For example, core transistor components having gate dielectric thicknesses of approximately less than 40 Angstroms may be formed with one or more high-k gate dielectric layers. In addition or in the alternative, core transistor components having gate dielectric thicknesses of approximately less than 20 Angstroms may be formed with one or more non-high-k gate dielectric layers. In selected embodiments, the gate dielectric of a core transistor may be formed as a stack of dielectrics, such a bottom gate dielectric interfacial layer formed with a non-high k dielectric material, and an upper gate dielectric layer formed with a high k dielectric material (e.g., Hafnium Oxide (HfO₂).

As disclosed herein, the formation of the interposer structure 36 using a silicon-based interposer substrate 10 enables thick gate oxide transistor devices 13 to be formed on the interposer structure 36 instead of the core device IC 34. This has the advantage of reducing the wafer cost and design cycle time for fabricating the interposer structure 36 since the design constraints for threshold voltages and critical patterning are not needed when only thick gate oxide transistor devices 13 are formed in the interposer structure 36. In addition, this allocation of thick gate oxide transistor devices 13 in the interposer structure 36 and thin gate oxide devices in the core device IC 34 means that the interposer structure 36 can be formed with the minimum number of BEOL layers to accommodate any I/O devices, decoupling capacitor, or RF devices, such as large area inductors. This can be important when the core device IC 34 is formed with advanced technologies, such as gate-all-around transistors, which do not include thick gate oxide FETs formed with thick gate oxides or include higher than core voltage levels. In the context of the present disclosure, it will be appreciated that a core voltage level refers to the allowable voltage of transistors with the thin gate oxides having a thickness that does not exceed a maximum thickness for the core device IC. In addition, the formation of seal ring structures 22, 25, spike vias 23, and through-substrate via copper pillar pads 24 using a single aluminum deposition step provides cost savings and mechanical stability for the interposer structure 36, regardless of how many ILD layers are in the BEOL stack 14. Another advantage of moving the thick gate oxide devices 13, capacitors and other RF passive devices to the interposer structure is that the advanced node chip design for the core device IC 34 can use fewer BEOL metal layers, thereby reducing fabrication costs for the core device IC 34. Also, using a silicon-based interposer substrate 10 helps prevent some CTE mismatching stresses.

As seen in Figure 8, the Aluminum via structures 23 formed in the stack of BEOL ILD layers 14 can be made to terminate in the BEOL, MEOL, FEOL levels by controlling the depth of the etch openings 19B in which the conductive barrier film layer and aluminum fill layer are deposited. In addition, the Aluminum via structures 24 formed in the stack of BEOL ILD layers 14 can be made to terminate in, or extends through, the silicon-based interposer substrate 10. Similarly, the Aluminum crack stop/edge seal structures 22, 25 can be made to extend through the stack of BEOL ILD layers 14 and the silicon-based interposer substrate 10.

For an improved understanding of selected embodiments of the present disclosure, reference is now made to Figures 9-14 which illustrate a sequence of cross-sectional and plan views at different stages of manufacture of an interposer structure which uses a passivation layer as a polish end-point layer. In particular, Figure 9 illustrates a cross-sectional view of a portion of an interposer structure 9 which may be formed as part of a semiconductor wafer wherein one or more BEOL inter-layer dielectric (ILD) layers 14 are formed over an interposer semiconductor substrate 10 in which one or more thick gate oxide IC devices or elements 13 are fabricated with FEOL wafer-processing steps. At the depicted fabrication stage, the interposer structure 9 is similar to the interpose structure 2 shown in Figure 2, so the details of the interposer substrate 10, thick gate oxide IC devices or elements 11-13, and BEOL ILD layers 14 will not be repeated. However, the interposer structure 9 does not include a passivation layer 15 on the stack of BEOL ILD layers 14. Instead, a patterned etch mask or photoresist (PR) layer 40A-C is formed on the stack of BEOL ILD layers 14, where the patterned PR layer 40A-C includes patterned etch mask openings 41A-D expose a top surface of the BEOL ILD layers 14 in accordance with selected embodiments of the present disclosure. As disclosed herein, any suitable photoresist patterning process may be used to form the patterned photoresist mask 40A-C, such as depositing, patterning, etching or developing a photoresist layer formed with any material that is suitable for photolithography. As formed, the patterned photoresist mask 40A-C exposes the stack of BEOL ILD layers 14 at intended etch locations for the full and partial stack via structures and seal ring/crack stop structures.

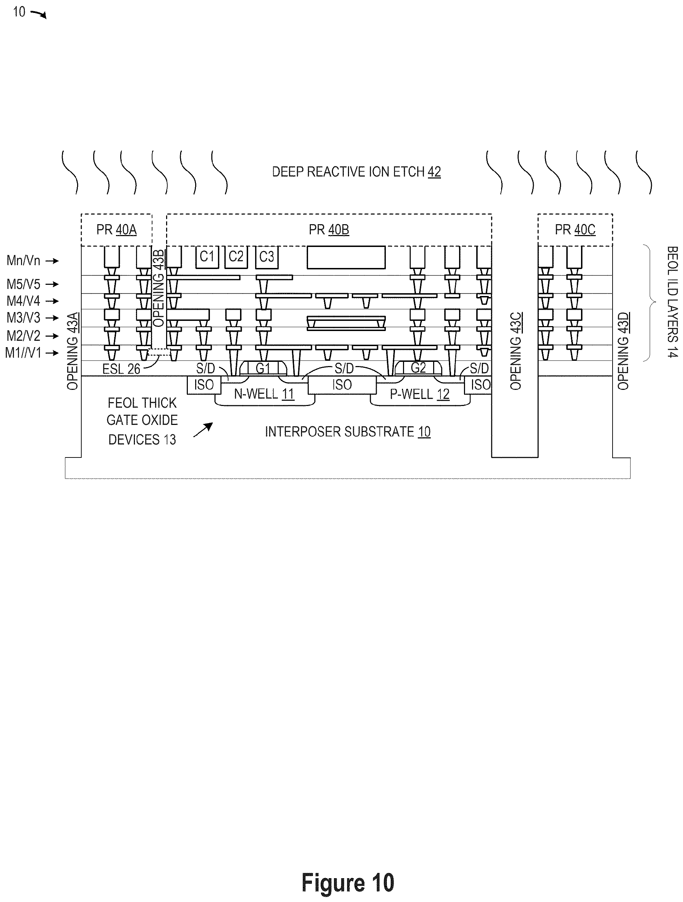

Figure 10 illustrates processing of the interposer structure 10 subsequent to Figure 9 after applying an etch process 42 to selectively etch openings 43A-D through the underlying stack of BEOL ILD layers 14 exposed by the etch mask openings 41A-D in the patterned photoresist mask 40A-C in accordance with selected embodiments of the present disclosure. As disclosed herein, the etch process 42 may use any suitable anisotropic etch process(es) to form the etching openings 43A-D which extend through the underlying stack of BEOL ILD layers 14 to a predetermined depth. For example, a single deep reactive-ion etch (RIE) step 42 may be applied to the patterned photoresist mask 40A-C which has defined etch mask openings 41A-D having wider width dimensions for the etch openings 43A, 43C, 43D and narrower width dimensions for the etch opening 43B, where the depth of each etch opening 43A-D is based on the relative size of the width dimensions of the etch mask openings 41A-D. Alternatively and as indicated by the dashed lines of the patterned photoresist mask 40A-C, separate patterned etch masks and deep RIE etch processing steps may be applied to define the relatively shallow etch opening 43B and the relatively deep etch openings 43A, 43C-D. In yet another embodiment, an etch stop layer (ESL) 26 formed in the stacked BEOL ILD layers 14 may be used to stop the progress of the etch process 42 so that the depth of the etch opening 43B is controlled.

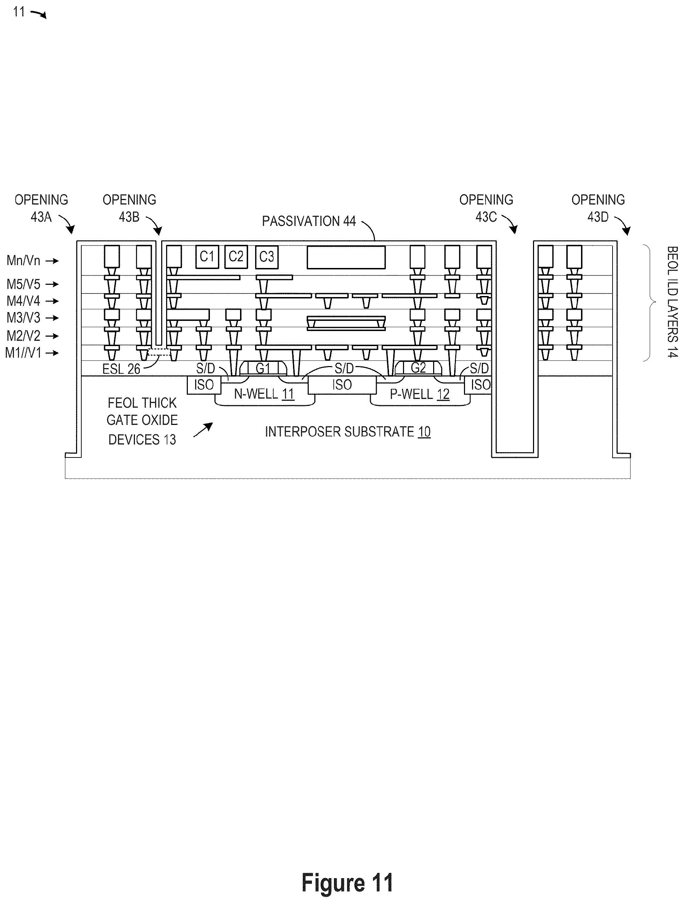

Figure 11 illustrates processing of the interposer structure 11 subsequent to Figure 10 after stripping the patterned photoresist mask 40A-C and forming a passivation layer 44 over the top surface of the BEOL ILD layers 14. As disclosed herein, the passivation layer 44 may be formed with any suitable fabrication process, such as by depositing one or more suitable dielectric passivation layers (e.g., polyimide, SiN, SiC, SiCN, SiON, SiOₓ, SiₓN_{y}, SiCON, a-C or combinations and variations thereof, some of which may also be fluorinated) to a predetermined thickness. As deposited, the passivation layer 44 covers the top of the interposer structure 11 coats the interior sidewalls and bottom of the etch openings 43A-D.

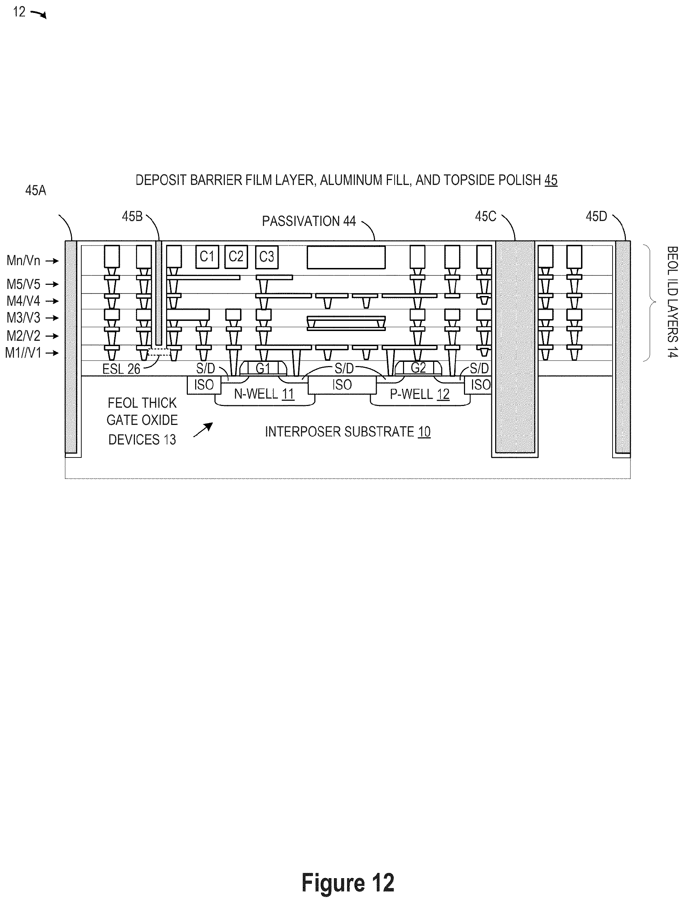

Figure 12 illustrates processing of the interposer structure 12 subsequent to Figure 11 after applying a sequence of steps 45 to fill the etch openings 43A-D with one or more deposited metal layers 45A-D in accordance with selected embodiments of the present disclosure. As disclosed herein, the metal layers 45A-D may be formed with any suitable fabrication process steps 45, such as by depositing a barrier film layer and aluminum fill layer and then applying a topside polish step to planarize the deposited metal layers 45A-D with the passivation layer 44 formed on top of the BEOL ILD layers 14. For example, the metal layers 45A-D may be formed by depositing TiN as a conformal barrier diffusion liner layer along the interior sidewalls of the etch openings 43A-D, and then depositing Aluminum on the conductive barrier diffusion liner layer to fill the etch openings 43A-D, and then planarizing the deposited metal layers 45A-D with a topside polish step, such as by using a chemical mechanical polish (CMP) planarization process.

Though Figure 12 shows that all of the etched openings 43A-D are lined with the passivation layer 44 before forming the conductive barrier film and aluminum fill layers 454A-D, in selected embodiments, the interposer structure may be formed with a combination of passivation lined etch openings (such as shown in Figure 12) and with etch openings that do not include a passivation lining layer (such as shown in Figure 6). In such embodiments, the passivation layer 44 can be deposited as a sidewall/bottom passivation liner layer in all etch openings 43A-D, and then completely stripped from some selected etch openings before forming the conductive barrier film liner and aluminum fill layer. For example, after forming the passivation layer 44 as a sidewall/bottom passivation liner layer in all etch openings 43A-D, a patterned mask may be formed on the interposer structure and a suitable strip or etch process may be applied to remove the sidewall/bottom passivation liner layer from the etch openings exposed by the patterned mask. After stripping the patterned mask, the conductive barrier film liner and aluminum fill layer may be formed in all etched openings.

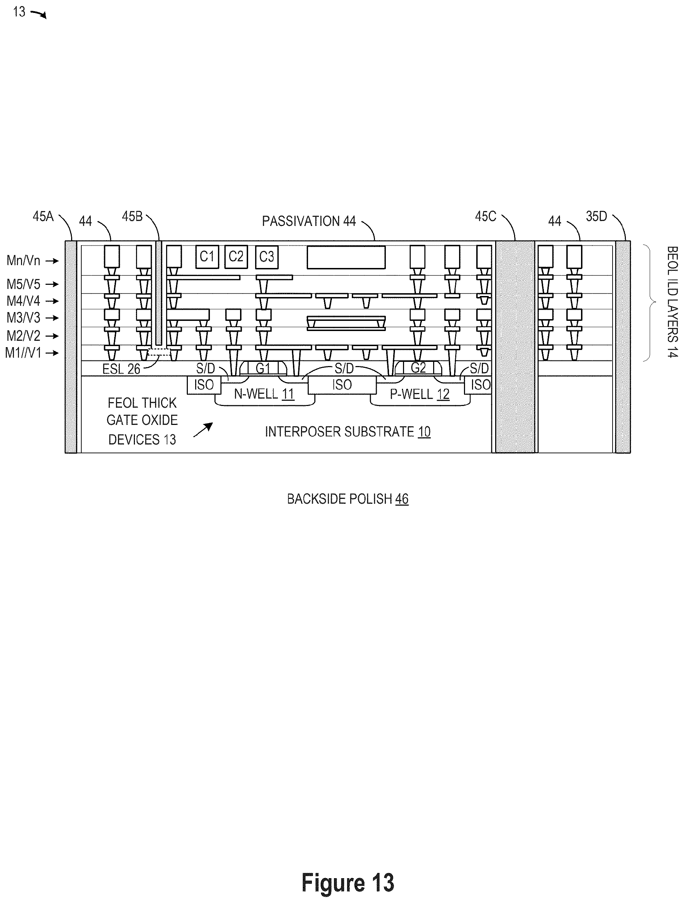

Figure 13 illustrates processing of the interposer structure 13 subsequent to Figure 12 after performing a backside etch or polish step 46 in accordance with selected embodiments of the present disclosure. As disclosed herein, the backside polish step 46 may use any suitable fabrication process to expose the deeper metal layers 45A, 45C-D on the back surface of the etched interposer substrate 10, such as by applying a chemical mechanical polish (CMP) planarization process to thin the interposer substrate 10 and expose the metal layers 45A, 45C-D. In such embodiments, the passivation layer 44 previously formed at the bottom of the etch openings 43A, 43C-D can serve as a CMP polish end-point determinant to control the extent and duration of the backside etch or polish step 46.

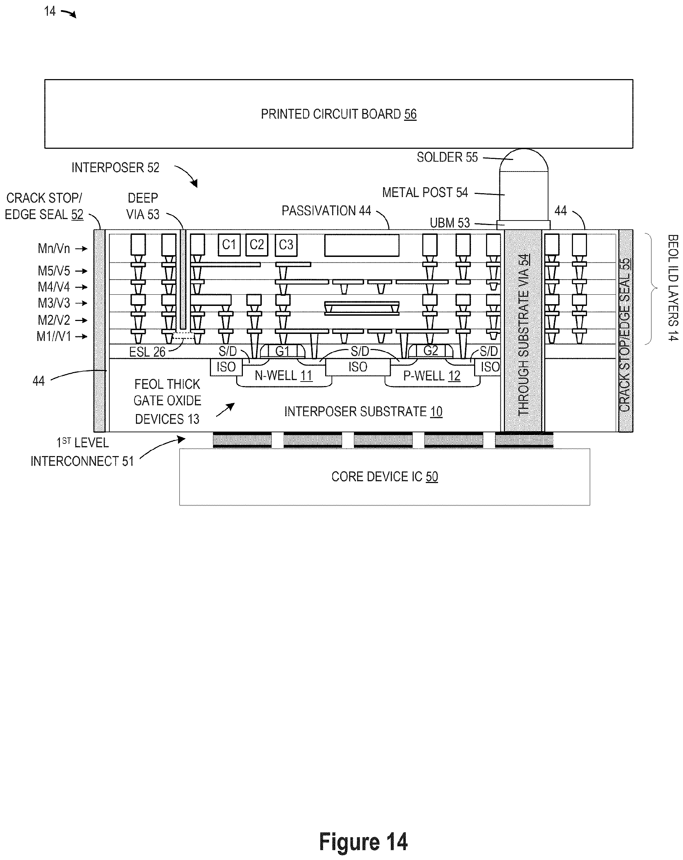

For an improved understanding of selected embodiments of the present disclosure, reference is now made to Figure 14 which depicts a simplified cross-section view of an integrated circuit package assembly 14 after affixing or mounting one or more core device integrated circuits 50 with first level interconnects 51 to an interposer structure 52. When implemented as a flip chip package, the core device IC 50 is connected to the printed circuit board 56 using defined conductive element paths in the interposer structure 52. In particular, the core device IC 50 is attached to a first or bottom surface of the interposer substrate 52 using a set of first level interconnects 51, such as solder bumps or micro-bump conductors. In similar fashion, a second or top surface of the interpose substrate 52 is attached to the printed circuit board 56 using a set of second level interconnects which may be formed with an UMB layer 53, copper or metal post 54, and solder ball or bump 55. In the depicted integrated circuit package assembly 14, the interposer structure 52 includes only non-core device components (such as thick gate oxide transistors and/or radio frequency (RF) elements) which are formed in the stack of BEOL interconnect stack 14 which includes partial stack aluminum via structures 53, full stack aluminum via structures 54, and/or seal ring/crack stop structures 52, 54 which are formed by selectively etching deep trench openings in the full BEOL interconnect stack 14 to one or more predetermined depths and then filling the deep trench openings with a barrier liner layer and deposited Aluminum to form Aluminum via structures and seal ring/crack stop structures52-55. By forming a low cost interposer structure 52 to include non-core device components, the core device IC 50 may be formed with core device components (such as advanced node core transistors or memory transistors) using an advanced-node, costly silicon high speed die that is connected to the low cost interposer structure 52 by suitable interconnect conductors 51. In this way, the functional circuitry is divided between the low cost interposer structure 52 and advanced-node, costly silicon high speed die 50 so that the wafer cost and cycle time is greatly reduced.

As described hereinabove, the present disclosure provides a mechanism for integrating conductive via structures and seal ring/crack stop structures in an interposer structure which includes only non-core device components (such as thick gate oxide transistors and/or radio frequency (RF) elements) so that core device components (such as advanced node core transistors or memory transistors) can be formed in an advanced-node, costly silicon high speed die. With the disclosed conductive via structures and seal ring/crack stop structures being formed in the low-cost interposer structure with a single aluminum deposition step, the wafer cost and cycle time for fabricating the interposer structure will be greatly reduced since there are no threshold voltage or critical patterning constraints for the interposer structure. In addition, the number of BEOL ILD layers for the interposer structure is minimized to accommodate the non-core device components, such as I/O transistors, capacitors, inductors, transmission lines, and baluns formed in the interposer structure. Shorter BEOL ILD stacks also results in further cost savings and improved mechanical stability from fabricating the conductive vias, seal ring structures, and TSV copper pillar pads in the BEOL ILD stacks of the interposer structure. In addition, the fabrication costs for the core device IC may be reduced by using fewer metal layers. Also, using a silicon-based interposer structure helps prevent some CTE mismatching stresses.

By now, it should be appreciated that there has been provided a package assembly and associated method of fabrication. In the disclosed methodology, a semiconductor interposer structure is formed which includes a back-end-of-line (BEOL) inter-level dielectric (ILD) stack formed over a silicon substrate layer in which is formed a plurality of front-end-of-line (FEOL) integrated circuit (IC) transistor devices with one or more gate dielectric layers having a specified minimum thickness, where the BEOL ILD stack comprises a plurality of conductive interconnect structures extending through the BEOL ILD stack and a plurality of aluminum via structures and aluminum crack stop structures extending from a top surface of the BEOL ILD stack at least part way down through the BEOL ILD stack. In selected embodiments, the semiconductor interposer structure is formed by forming the plurality of FEOL IC transistor devices at least partly in the silicon substrate layer; forming the BEOL ILD stack over the plurality of FEOL IC transistor devices and the silicon substrate layer; selectively etching a plurality of etch openings extending from a top surface of the BEOL ILD stack at least part way down through the BEOL ILD stack; and filling the plurality of etch openings with at least deposited aluminum to form the plurality of aluminum via structures and aluminum crack stop structures. In selected embodiments, the BEOL ILD stack is formed with capacitor structures and/or inductor structures in the BEOL ILD stack. In other selected embodiments, selectively etching the plurality of etch openings includes selectively etching one or more deep trench through substrate via openings extending through the BEOL ILD stack and the silicon substrate layer; selectively etching one or more partial trench via openings extending from the top surface of the BEOL ILD stack and only part way down through the BEOL ILD stack; and selectively etching deep trench crack stop openings extending through the BEOL ILD stack and the silicon substrate layer. In other selected embodiments, filling the plurality of etch openings includes depositing a barrier liner layer to conformally cover sidewall and bottom surfaces of the plurality of etch openings; depositing aluminum to fill the plurality of etch openings; and applying a topside polish step to substantially planarize the deposited aluminum and barrier liner layer with the top surface of the BEOL ILD stack. The disclosed methodology also attaching, to a first surface of the semiconductor interposer structure, one or more core device integrated circuit devices, each formed with a plurality of core transistors with one or more gate dielectric layers having a specified maximum thickness that is smaller or less than the specified minimum thickness. In selected embodiments, the disclosed methodology also includes attaching a printed circuit board to a second, opposed surface of the semiconductor interposer structure. In selected embodiments, the specified maximum thickness for the one or more gate dielectric layers in the plurality of core transistors is approximately 40 Angstroms, and the specified minimum thickness for the one or more gate dielectric layers in the plurality of FEOL IC transistor devices is at least approximately 50 Angstroms. In selected embodiments, the disclosed methodology may also include forming a passivation layer over the BEOL ILD stack before or after selectively etching one or more deep trench through substrate via openings.

In another form, there has been provided an interposer structure and associated method of fabrication. In the disclosed methodology, a semiconductor interposer wafer substrate layer is provided with a plurality of front-end-of-line (FEOL) integrated circuit (IC) transistor devices with gate oxides having a minimum thickness of approximately 50 Angstroms. The disclosed methodology also includes forming, over the semiconductor interposer wafer substrate layer, a back-end-of-line (BEOL) inter-level dielectric (ILD) stack having a plurality of conductive interconnect structures extending through a plurality of interconnect levels in the BEOL ILD stack. In selected embodiments, forming the BEOL ILD stack also includes forming capacitor structures and/or inductor structures in the BEOL ILD stack. The disclosed methodology also includes selectively etching a plurality of etch openings extending from a top surface of the BEOL ILD stack at least part way down past at least a top interconnect level of the BEOL ILD stack. In selected embodiments, selectively etching the plurality of etch openings includes selectively etching one or more deep trench through substrate via openings extending through the BEOL ILD stack and the semiconductor interposer wafer substrate layer; selectively etching one or more partial trench via openings extending from the top surface of the BEOL ILD stack and only part way down through the BEOL ILD stack; and selectively etching deep trench crack stop openings extending through the BEOL ILD stack and the semiconductor interposer wafer substrate layer. In selected embodiments, the deep trench through substrate via openings, partial trench via openings, and deep trench crack stop openings may be selectively etched with a single deep RIE etch step using a single etch mask with patterned openings of different sizes. In other selected embodiments, the deep trench through substrate via openings, partial trench via openings, and deep trench crack stop openings may be selectively etched with separate deep RIE etch steps using a plurality of separate etch masks and RIE etch steps in sequence. In selected embodiments, a passivation layer is formed on the top surface of the BEOL ILD stack before selectively etching the plurality of etch openings. In addition, the disclosed methodology includes filling the plurality of etch openings with at least deposited aluminum to form a plurality of aluminum via structures and aluminum crack stop structures extending from a top surface of the BEOL ILD stack at least part way down through the BEOL ILD stack. In selected embodiments, the plurality of etch openings may be filled by depositing a barrier liner layer to conformally cover sidewall and bottom surfaces of the plurality of etch openings; depositing aluminum to fill the plurality of etch openings; and applying a topside polish step to substantially planarize the deposited aluminum and barrier liner layer with the top surface of the BEOL ILD stack. In selected embodiments, a passivation layer is formed on the top surface of the BEOL ILD stack and on sidewall and bottom surfaces of the plurality of etch openings before filling the plurality of etch openings. The disclosed methodology also includes partially recessing a bottom surface of the semiconductor interposer wafer substrate layer to expose at least the aluminum crack stop structures. In selected embodiments, the disclosed methodology may also include cutting through the aluminum crack stop structures in the BEOL ILD stack and the semiconductor interposer wafer substrate layer to singulate the plurality of FEOL IC transistor devices in an interposer structure. In selected embodiments, the bottom surface of the semiconductor interposer wafer substrate layer is partially etched by performing a backside etch or polish step to thin the semiconductor interposer wafer substrate layer and expose at least the aluminum crack stop structures. In selected embodiments, the disclosed methodology may also include affixing, to the bottom surface of the semiconductor interposer wafer substrate layer, a core device integrated circuit device in which is formed a plurality of core transistor devices with gate oxides having a maximum thickness of approximately 10-40 Angstroms. In selected embodiments, the core device integrated circuit device may be affixed to the bottom surface of the semiconductor interposer wafer substrate layer using chip-to-chip bonding.

In yet another form, there has been provided an electronic device and associated method of fabrication. As disclosed, the electronic device includes a semiconductor interposer structure with a back-end-of-line (BEOL) inter-level dielectric (ILD) stack positioned over a silicon substrate layer in which is formed a plurality of front-end-of-line (FEOL) integrated circuit (IC) transistor devices with gate oxides having a specified minimum thickness, where the BEOL ILD stack includes a plurality of conductive interconnect structures extending through a plurality of interconnect levels in the BEOL ILD stack and a plurality of aluminum via structures and aluminum crack stop structures extending from a top surface of the BEOL ILD stack at least part way down past at least a first interconnect level of the BEOL ILD stack. In addition, the disclosed electronic device includes a first plurality of interconnect conductors located on a first surface of the semiconductor interposer structure and in electrical contact with the plurality of aluminum via structures. The disclosed electronic device also includes a second plurality of interconnect conductors located on a second surface of the semiconductor interposer structure and in electrical contact with the plurality of aluminum via structures. In addition, the disclosed electronic device includes one or more core device integrated circuit devices attached to the first or second plurality of interconnect conductors, where each core device integrated circuit device includes a plurality of core transistors with gate oxides having a specified maximum oxide thickness that is smaller than the specified minimum thickness. In selected embodiments, each of the plurality of core transistors has gate oxides having a thickness that is less than approximately 40 Angstroms and where each of the plurality of FEOL IC transistor devices has gate oxides having a thickness that is greater than approximately 50 Angstroms.

Although the described exemplary embodiments disclosed herein are directed to various semiconductor and IC device structures and methods for making the same, the present invention is not necessarily limited to the example embodiments which illustrate inventive aspects of the present invention that are applicable to a wide variety of semiconductor processes and/or devices. Thus, the particular embodiments disclosed above are illustrative only and should not be taken as limitations upon the present invention, as the invention may be modified and practiced in different but equivalent manners apparent to those skilled in the art having the benefit of the teachings herein. Accordingly, the foregoing description is not intended to limit the invention to the particular form set forth, but on the contrary, is intended to cover such alternatives, modifications and equivalents as may be included within the scope of the invention as defined by the appended claims so that those skilled in the art should understand that they can make various changes, substitutions and alterations without departing from the scope of the invention in its broadest form.

As used herein, the term "approximately", when applied to a thickness shall be understood to mean, where appropriate, within 10 per cent of the stated value.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. A process for making a package assembly, comprising:
forming a semiconductor interposer structure comprising a back-end-of-line, BEOL, inter-level dielectric, ILD, stack formed over a silicon substrate layer in which is formed a plurality of front-end-of-line, FEOL, integrated circuit, IC, transistor devices formed with one or more gate dielectric layers having a specified minimum thickness, where the BEOL ILD stack comprises a plurality of conductive interconnect structures extending through the BEOL ILD stack and a plurality of aluminum via structures and aluminum crack stop structures extending from a top surface of the BEOL ILD stack at least part way down through the BEOL ILD stack; and
attaching, to a first surface of the semiconductor interposer structure, one or more core device integrated circuit devices, each formed with a plurality of core transistors with one or more gate dielectric layers having a specified maximum thickness that is smaller than the specified minimum thickness.

2. The process of claim 1, further comprising attaching a printed circuit board to a second, opposed surface of the semiconductor interposer structure.

3. The process of claim 1 or 2, where the specified maximum thickness for the one or more gate dielectric layers in the plurality of core transistors is approximately 40 Angstroms and where the specified minimum thickness for the one or more gate dielectric layers in the plurality of FEOL IC transistor devices is at least approximately 50 Angstroms.

4. The process of any of claims 1 to 3, where forming the semiconductor interposer structure comprises:
forming the plurality of FEOL IC transistor devices at least partly in the silicon substrate layer;
forming the BEOL ILD stack over the plurality of FEOL IC transistor devices and the silicon substrate layer;
selectively etching a plurality of etch openings extending from a top surface of the BEOL ILD stack at least part way down through the BEOL ILD stack; and
filling the plurality of etch openings with at least deposited aluminum to form the plurality of aluminum via structures and aluminum crack stop structures.

5. The process of claim 4, where forming the BEOL ILD stack comprises forming capacitor structures and/or inductor structures in the BEOL ILD stack.

6. The process of claim 4 or 5, where selectively etching the plurality of etch openings comprises:
selectively etching one or more deep trench through substrate via openings extending through the BEOL ILD stack and the silicon substrate layer;
selectively etching one or more partial trench via openings extending from the top surface of the BEOL ILD stack and only part way down through the BEOL ILD stack; and
selectively etching deep trench crack stop openings extending through the BEOL ILD stack and the silicon substrate layer.

7. The process of any of claims 4 to 6, where filling the plurality of etch openings comprises:
depositing a barrier liner layer to conformally cover sidewall and bottom surfaces of the plurality of etch openings;
depositing aluminum to fill the plurality of etch openings; and
applying a topside polish step to planarize or substantially planarize the deposited aluminum and barrier liner layer with the top surface of the BEOL ILD stack.

8. The process of any of claims 4 to 7, further comprising forming a passivation layer over the BEOL ILD stack before or after selectively etching one or more deep trench through substrate via openings.

9. An electronic device, comprising:
a semiconductor interposer structure comprising a back-end-of-line, BEOL, inter-level dielectric, ILD, stack positioned over a silicon substrate layer in which is formed a plurality of front-end-of-line, FEOL, integrated circuit, IC, transistor devices with gate oxides having a specified minimum thickness, where the BEOL ILD stack comprises a plurality of conductive interconnect structures extending through a plurality of interconnect levels in the BEOL ILD stack and a plurality of aluminum via structures and aluminum crack stop structures extending from a top surface of the BEOL ILD stack at least part way down past at least a first interconnect level of the BEOL ILD stack;
a first plurality of interconnect conductors located on a first surface of the semiconductor interposer structure and in electrical contact with the plurality of aluminum via structures;
a second plurality of interconnect conductors located on a second surface of the semiconductor interposer structure and in electrical contact with the plurality of aluminum via structures; and
one or more core device integrated circuit devices attached to the first or second plurality of interconnect conductors, where each core device integrated circuit device comprises a plurality of core transistors with gate oxides having a specified maximum oxide thickness that is smaller than the specified minimum thickness.

10. The integrated-circuit of claim 9, where each of the plurality of core transistors has gate oxides having a thickness that is less than approximately 40 Angstroms and where each of the plurality of FEOL IC transistor devices has gate oxides having a thickness that is greater than approximately 50 Angstroms.
